Europäisches Patentamt

European Patent Office

Office européen des brevets

(19)

(11) EP 0 744 687 A1

## (12) DEMANDE DE BREVET EUROPEEN

(43) Date de publication:
27.11.1996 Bulletin 1996/48

(51) Int Cl.⁶: **G06F 7/50**, H03K 19/173,
H03K 19/0948

(21) Numéro de dépôt: 96410057.2

(22) Date de dépôt: 21.05.1996

(84) Etats contractants désignés:
**DE FR GB IT**

(30) Priorité: **24.05.1995 FR 9506406**

(71) Demandeur: SGS-THOMSON
MICROELECTRONICS S.A.
94250 Gentilly (FR)

(72) Inventeurs:
• Gonfaus, Christine
38130 Echirolles (FR)
• Lebrun, Jacky
38100 Grenoble (FR)

(74) Mandataire: de Beaumont, Michel
1bis, rue Champollion
38000 Grenoble (FR)

### (54) Circuit logique combinatoire

(57)    La présente invention concerne un circuit logique combinatoire comprenant au moins une paire d'entrées (A,B) et une ligne de sortie (C*) ; au moins un premier module (1b, 1a) et un module symétrique (1d,1c) ; un premier module comprenant une cellule parallèle (1b) et une cellule série (1a) ; une cellule parallèle (1b) comprenant deux interrupteurs commandés par la paire d'entrées et en parallèle entre une borne d'alimentation (VDD) et une borne de sortie couplée à la ligne de sortie ; une cellule série (1a) comprenant deux interrupteurs commandés par la paire d'entrées et en série entre l'alimentation et la ligne de sortie ; un module symétrique comprenant deux cellules symétriques de celles du premier module, par rapport à la ligne de sortie, couplées à une seconde alimentation (GND) et commandées en opposition de phase.

Fig 2

## Description

La présente invention concerne la réalisation de circuits logiques combinatoires et en particulier de circuits additionneurs à calcul anticipé de retenue.

Les circuits combinatoires classiques, en particulier les additionneurs, sont réalisés à partir de portes logiques. Ces portes logiques sont souvent connectées en cascade, ce qui allonge le temps de calcul car la sortie d'une porte n'est valable que lorsque les sorties des portes précédentes le sont.

De façon générale, pour réaliser un additionneur, on connecte des additionneurs simples en cascade, une entrée de retenue de chaque additionneur simple étant connectée à une sortie de retenue de l'additionneur simple précédent. Le temps de calcul de la retenue est un paramètre critique car le résultat d'un additionneur en cascade, y compris sa retenue, n'est valable que lorsque l'additionneur précédent lui fournit une retenue valable.

Les additionneurs les plus rapides, tels que les circuits TTL '83 et '283 (additionneurs 4 bits), effectuent un calcul anticipé de retenue (lookahead). Dans ces additionneurs, la retenue fait l'objet d'un calcul indépendant des additions bit à bit, le circuit combinant directement les entrées. Ainsi, le calcul de la retenue est effectué sensiblement en même temps que les additions bit à bit.

Le temps de calcul de la retenue est déterminé par le trajet le plus long des signaux depuis les entrées jusqu'à la sortie de retenue. Ce trajet comprend des portes logiques disposées selon un certain nombre de couches logiques, une couche logique comprenant des portes logiques élémentaires dont les entrées sont alimentées par les sorties de portes élémentaires de la couche précédente. Chaque couche logique introduit le retard de propagation d'une porte élémentaire. Les additionneurs '83 ou '283 comportent quatre couches logiques pour la sortie de retenue. Leur circuit entier est un circuit complexe comprenant 232 transistors.

Les additionneurs 8 bits ou 16 bits sont généralement réalisés avec des additionneurs 4 bits connectés en cascade, car cela s'avère plus avantageux que de réaliser un circuit de calcul anticipé de retenue à 8 ou 16 bits.

On a aussi proposé (voir par exemple IBM TDB, vol. 30, N°7, Dec. 1987, P. 132-133 ; WO-A-85/05705 ; US-A-4601007) des cellules d'additionneurs et de calcul de retenue faite à partir de cellules à deux transistors MOS qui seront décrites ci-après. Toutefois, pour additionner plus de deux bits, on utilise comme dans l'art antérieur des cellules en cascade et ces documents ne suggèent pas de circuit de calcul anticipé de retenue.

Un objet de la présente invention est de réduire le temps de calcul d'un circuit logique combinatoire en particulier d'un additionneur à calcul anticipé de retenue.

Un autre objet de la présente invention est de réduire le nombre de transistors nécessaires pour réaliser une fonction logique.

Ces objets sont atteints en réalisant un circuit logique à partir d'un assemblage de cellules à deux transistors et non de portes logiques.

Plus particulièrement, la présente invention prévoit un procédé de réalisation d'un circuit logique combinatoire fournissant sur au moins une ligne de sortie une combinaison commutative spécifique d'au moins deux couples d'entrées, comprenant les étapes suivantes :

- établir une première expression (f(A*,B*)) de ladite combinaison comportant uniquement des termes correspondant à des fonctions ET et OU des valeurs inversées desdites entrées ;
- établir une deuxième expression (g(A,B)) de l'inverse de ladite combinaison comportant uniquement des termes correspondant à des fonctions ET et OU des valeurs non-inversées desdites entrées ;
- constituer entre une première tension d'alimentation (VDD) et la ligne de sortie (C*), un premier réseau correspondant à la première expression (f(A*,B*)), comprenant :

  . pour chaque terme ET, une paire d'interrupteurs connectés en série (0a, 1a),
  . pour chaque terme OU, une paire d'interrupteurs connectés en parallèle (0b, 1b),

- constituer entre une seconde tension d'alimentation (GND) et la ligne de sortie (C*), un second réseau correspondant à la seconde expression (g(A,B)), comprenant :

  . pour chaque terme ET, une paire d'interrupteurs connectés en série (0c, 1c),
  . pour chaque terme OU, une paire d'interrupteurs connectés en parallèle (0d),(1d),

les interrupteurs d'une paire étant commandés par l'une et l'autre des entrées d'un couple d'entrées, les interrupteurs des premier et second réseaux étant de type complémentaire et étant commandés en phase.

Selon un mode de réalisation de la présente invention, ce procédé comprend l'étape consistant à remplacer un groupe de cellules en série entre deux bornes par un interrupteur connecté entre les deux bornes et précédé d'un inverseur dont l'entrée est connectée à une première ligne d'alimentation par un groupe direct de cellules et à une deuxième ligne d'alimentation par un groupe complémentaire de cellules ; le groupe direct étant identique au groupe de cellules remplacées ; le groupe complémentaire comprenant pour chaque cellule parallèle du groupe direct, une cellule série, et inversement ; les cellules du groupe complémentaire étant connectées entre elles en série si les cellules du groupe direct sont connectées en parallèle, et inversement.

Selon un mode de réalisation de la présente invention, ladite combinaison est une addition logique.

Selon un mode de réalisation de la présente invention, ladite combinaison est une fonction de calcul anticipé de retenue d'additionneur logique ayant au moins deux fois n entrées (n>1).

Selon un mode de réalisation de la présente invention, l'additionneur logique a une entrée de retenue.

La présente invention vise aussi un circuit logique combinatoire comportant au moins n couples d'entrées (n>1) et une ligne de sortie, comprenant au moins n premiers modules et n modules symétriques ; un premier module comprenant une cellule parallèle et une cellule série ; une cellule parallèle comprenant deux interrupteurs commandés par un couple d'entrées et en parallèle entre une borne d'alimentation couplée à une première tension d'alimentation et une borne de sortie couplée à la ligne de sortie ; une cellule série comprenant deux interrupteurs commandés par le couple d'entrées et en série entre ladite borne d'alimentation et la ligne de sortie ; la borne d'alimentation de la cellule parallèle de chaque module de rang k (k variant de 1 à n-1) étant connectée à la borne de sortie de la cellule du module de rang k+1 ; un module symétrique comprenant deux cellules complémentaires et symétriques de celles du premier module par rapport à la ligne de sortie, couplées à une seconde tension d'alimentation et commandées en phase.

Selon un mode de réalisation de la présente invention, le circuit logique combinatoire comprend un autre couple d'entrées, la borne de sortie de la cellule parallèle du module de rang 1 étant connectée à la ligne de sortie par deux interrupteurs en parallèle commandés respectivement par les entrées de l'autre couple d'entrées, la borne de sortie de la cellule symétrique à la cellule parallèle du module de rang 1 étant connectée à la ligne de sortie par deux interrupteurs en série, commandés respectivement par les entrées de l'autre couple d'entrées.

Selon un mode de réalisation de la présente invention, le circuit logique combinatoire comprend une entrée supplémentaire et deux interrupteurs complémentaires supplémentaires commandés par l'entrée supplémentaire, la borne de sortie de la cellule parallèle du module de rang 1 étant connectée à la ligne de sortie par l'un des deux interrupteurs supplémentaires, la borne de sortie de la cellule parallèle du module symétrique de rang 1 étant connectée à la ligne de sortie par l'autre interrupteur supplémentaire.

Ces objets, caractéristiques, avantages ainsi que d'autres de la présente invention seront exposés en détail dans la description suivante de modes de réalisation particuliers, faite, à titre non-limitatif, à l'aide des figures jointes parmi lesquelles :

les figures 1A à 1D représentent quatre cellules à deux transistors utilisées selon l'invention ;

la figure 2 représente un mode de réalisation selon l'invention d'un circuit de calcul anticipé de retenue d'un additionneur à 2 bits ;

la figure 3 représente un mode de réalisation selon l'invention d'un circuit de calcul anticipé de retenue d'un additionneur à 4 bits ; et

les figures 4A et 4B illustrent une variante du circuit de la figure 2.

Pour réduire le temps de calcul d'un circuit logique combinatoire, et aussi réduire son nombre de transistors, la présente invention prévoit un procédé de réalisation du circuit à partir de cellules à deux transistors dont l'agencement est déterminé par une analyse de la fonction logique du circuit.

Le procédé selon l'invention s'applique à des circuits combinatoires qui comprennent 2n entrées qui peuvent être interverties sans que le résultat de la fonction logique change. En termes mathématiques, il s'applique à des circuits logiques mettant en oeuvre des opérations commutatives. C'est par exemple le cas d'un additionneur.

L'invention est basée sur l'utilisation de quatre types de cellules. Chaque cellule est constituée de deux transistors MOS, fonctionnant en interrupteurs qui, selon leur état passant ou bloqué, établissent un couplage entre une tension d'alimentation et une ligne de sortie. Chaque cellule comporte deux bornes de commande correspondant aux grilles des transistors MOS et deux bornes principales qui seront appelées borne de source S et borne de drain D.

Comme on le verra dans la suite de la description, les cellules sont connectables en série entre une tension d'alimentation et une ligne de sortie commune, une borne de drain D d'une cellule étant connectée à une borne de source S d'une autre cellule. Elles sont aussi connectables en parallèle, deux bornes de source S de deux cellules étant connectées ensemble et couplées à une tension d'alimentation ("couplé" signifie ici connecté avec interposition éventuelle d'autres cellules), deux bornes de drain D étant connectées ensemble et couplées à la ligne de sortie.

Parmi les quatre cellules, on distingue deux cellules de mise à 1 constituées de transistors MOS à canal P, et deux cellules de mise à 0 constituées de transistors MOS à canal N. Les cellules de mise à 1 sont destinées à être disposées dans un réseau compris entre la ligne de sortie et une première tension d'alimentation de niveau logique 1 (appelée par la suite "alimentation VDD"). Les cellules de mise à 0 sont destinées à être disposées dans un réseau compris entre la ligne de sortie et une seconde tension d'alimentation de niveau logique 0 (appelée par la suite "masse GND").

Pour exposer le procédé selon l'invention, il est commode d'associer à chacune des cellules une fonction logique comme s'il s'agissait d'une porte logique fournissant un état logique 0 ou 1. Cependant ces cellules fonctionnent comme des interrupteurs dont la borne de sortie, appelée ici borne de drain D, est reliée à une tension d'alimentation ou est déconnectée.

Dans le cas des cellules de mise à 1, l'état de sortie est 1 ou x, x indiquant l'état dans lequel la borne de drain D est déconnectée. L'état x des cellules de mise à 1 peut être assimilé à l'état logique 0 en supposant que des cellules de mise à 0 connectent la ligne de sortie à la masse GND chaque fois que les cellules de mise à 1 fournissent l'état x.

Dans le cas des cellules de mise à 0, l'état de sortie est représenté par 0 ou x. L'état x des cellules de mise à 0 peut être assimilé à l'état logique 1 en supposant que des cellules de mise à 1 connectent la ligne de sortie à l'alimentation VDD chaque fois que les cellules de mise à 0 fournissent l'état x.

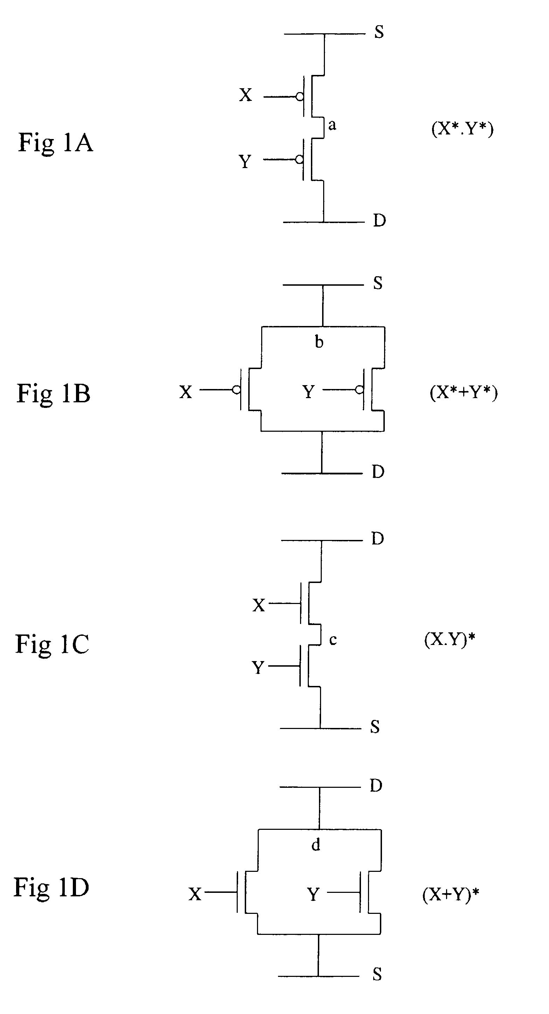

Dans un circuit, les cellules de mise à 1 seront commandées pour ne pas pouvoir fournir l'état logique 1 en même temps que les cellules de mise à 0 fournissent l'état logique 0. Les figures 1A à 1D représentent les quatre cellules utilisées selon l'invention. Chaque cellule effectue une seule opération logique et comprend deux transistors MOS dont les grilles reçoivent des entrées X et Y.

La figure 1A représente une première cellule, dite cellule série de mise à 1, constituée de deux transistors MOS à canal P en série entre une borne de drain D et une borne de source S destinée à être couplée à l'alimentation VDD. L'état de la borne de drain D en fonction des états des entrées X et Y est donné par :

TABLEAU I

| X | Y | D |
|---|---|---|
| 0 | 0 | 1 |
| 0 | 1 | x |
| 1 | 0 | x |
| 1 | 1 | x |

La fonction logique réalisée est donc D = X*.Y* (X* ET Y*), si l'état x est assimilé à l'état 0. Dans la présente demande, le symbole * est utilisé pour désigner un inverse.

La figure 1B représente une deuxième cellule, dite cellule parallèle de mise à 1, constituée de deux transistors MOS à canal P en parallèle entre une borne de drain D et une borne de source S destinée à être couplée à l'alimentation VDD. L'état de la borne de drain D en fonction des états des entrées X et Y est donné par :

TABLEAU II

| X | Y | D |
|---|---|---|
| 0 | 0 | 1 |
| 0 | 1 | 1 |
| 1 | 0 | 1 |
| 1 | 1 | x |

La fonction logique réalisé est donc D = X*+Y* (X* OU Y*), si l'état x est assimilé à l'état 0.

La figure 1C représente une troisième cellule, dite cellule série de mise à 0, constituée de deux transistors MOS à canal N en série entre une borne de drain D et une borne de source S destinée à être couplée à la masse GND. L'état de la borne de drain D en fonction des entrées X et Y est donné par :

TABLEAU III

| X | Y | D |
|---|---|---|
| 0 | 0 | x |
| 0 | 1 | x |
| 1 | 0 | x |
| 1 | 1 | 0 |

La fonction logique réalisée est donc D = (X.Y)*, si l'état x est assimilé cette fois-ci à l'état 1.

La figure 1D représente une quatrième cellule, dite cellule parallèle de mise à 0, constituée de deux transistors MOS à canal N en parallèle entre une borne de drain D et une borne de source S destinée à être couplée à la masse GND. L'état de la borne de drain D en fonction des entrées X et Y est donné par :

TABLEAU IV

| X | Y | D |
|---|---|---|
| 0 | 0 | x |
| 0 | 1 | 0 |
| 1 | 0 | 0 |
| 1 | 1 | 0 |

La fonction logique réalisée est donc D = (X+Y)*, si l'état x est assimilé à l'état 1.

Ainsi les deux premières cellules fournissent seulement des niveaux logiques 1 et les deux dernières cellules fournissent seulement des niveaux logiques 0.

La présente invention prévoit de réaliser un circuit combinatoire en faisant correspondre à une combinaison logique déterminée un circuit combinatoire comprenant une association de cellules parallèle et série.

De façon générale, l'association en série de deux cellules (ou de deux groupes de cellules) entre une tension d'alimentation et une ligne de sortie correspond à une opération logique ET entre les fonctions logiques respectives effectuées par ces deux cellules (ou ces deux groupes de cellules).

Si les entrées des cellules de mise à 1 sont à l'état logique 0, les cellules sont passantes. La ligne de sortie est alors à l'état logique 1. Les cellules de mise à 1 sont donc actives sur les inverses des entrées. L'état de sortie correspond à une opération logique simple effectuée sur l'inverse de chaque état d'entrée (bien qu'il n'y ait pas d'inversion réelle des entrées). C'est pourquoi les fonctions logiques effectuées par les cellules de mise à 1 ont été exprimées sous la forme (X*.Y*) et (X*+Y*).

Si les entrées des cellules de mise à 0 sont à l'état logique 1, les cellules sont passantes et la ligne de sortie est à l'état logique 0. Les cellules de mise à 0 sont donc actives sur les états non-inversés des entrées, mais c'est l'état de sortie qui est inversé. C'est pourquoi les fonctions logiques effectuées par les cellules de mise à 0 ont été exprimées sous la forme (X.Y)* et (X+Y)* alors qu'elles sont identiques aux fonctions logiques des cellules de mise à 1.

On peut trouver de la manière suivante la fonction logique effectuée par un circuit combinatoire composé de ce type de cellules.

- L'association en série de transistors, de cellules ou de groupes de cellules correspond à l'opération logique ET entre les fonctions logiques associées à ces transistors, cellules ou groupes de cellules.
- L'association en parallèle de transistors, de cellules ou de groupes de cellules correspond à l'opération logique OU entre les fonctions logiques associées à ces transistors, cellules ou groupes de cellules.
- Un réseau de mise à 1, c'est-à-dire composé uniquement de transistors et de cellules de mise à 1, correspond à une fonction logique effectuant l'ensemble d'opérations logiques de type ET et de type OU, cet ensemble d'opérations étant effectué sur les entrées des interrupteurs ou des cellules, mais chaque entrée étant remplacée artificiellement dans l'expression de la fonction logique par son inverse. La fonction logique du réseau de mise à 1 s'exprime donc sous la forme :

$$f(X^*, Y^*, Z^*;...),$$

la fonction f étant l'ensemble d'opérations logiques correspondant à la mise en parallèle et/ou série des transistors et des cellules de mise à 1.

- Un réseau de mise à 0, c'est-à-dire composé uniquement de transistors et de cellules de mise à 0, correspond à une fonction logique effectuant l'ensemble d'opérations logiques de type ET et de type OU, cet ensemble d'opérations étant effectué sur les entrées des transistors ou des cellules, les entrées n'étant pas remplacées par leur inverse mais l'ensemble de la fonction logique étant inversé artificiellement. La fonction logique du réseau de mise à 0 s'écrit donc sous la forme :

$$g^*(X, Y, Z, ...)$$

la fonction g étant l'ensemble d'opérations logiques correspondant à la mise en parallèle et/ou en série des transistors et des cellules de mise à 0.

Pour fonctionner, un circuit combinatoire comprend au moins un réseau de mise à 1 et au moins un réseau de mise à 0 commandés par les mêmes entrées dont les fonctions logiques sont égales, bien qu'exprimées sous forme différente, c'est-à-dire que :

$$f(X^*, Y^*, Z^*,...) = g^*(X, Y, Z,...)$$

Réciproquement, pour trouver à l'aide du procédé selon l'invention un circuit logique combinatoire ayant une fonction prédéterminée, on établit une première expression f et une seconde expression g qui sont deux expressions de la fonction prédéterminée transposables directement en les cellules susmentionnées.

De façon générale, les expressions f et g ne sont pas identiques. Les réseaux de mise à 0 et de mise à 1 ne sont alors pas identiques. Toutefois, dans des cas particuliers qui feront l'objet des exemples ci-après, ces expressions sont identiques. Les réseaux de mise à 0 et de mise à 1 le sont alors également. L'invention conduit alors à des structures particulièrement simples.

La présente invention vise plus particulièrement l'application du procédé ci-dessus à la réalisation de circuits logiques de calcul anticipé de retenue.

EXEMPLE 1 : CIRCUIT DE CALCUL ANTICIPÉ DE RETENUE D'UN ADDITIONNEUR DE DEUX NOMBRES DE 2 BITS.

On considèrera l'addition de deux nombres de 2 bits A et B, dont les bits sont désignés par A0, A1 et B0, B1, les bits de poids faible étant A0 et B0. Le résultat est un nombre S ayant 2 bits de somme S0, S1 et 1 bit de retenue C2. Une entrée de retenue C0 est prévue pour pouvoir connecter cet additionneur en cascade d'un autre.

L'équation générale factorisée du calcul anticipé de retenue à 2 bits peut s'écrire sous la forme :

$$C2 = (A1.B1)+(A1+B1).[(A0.B0)+(A0+B0).C0] \tag{1}$$

ou

$$C2^* = [(A1.B1)+(A1+B1).[(A0.B0)+(A0+B0).C0]]^* \tag{2}$$

Cette expression de $C2^*$ correspond directement à la forme recherchée d'une expression g. En effet, on a bien :

$$C2^* = g^*(A1,B1,A0,B0,C0)$$

Pour établir l'expression f correspondante, il faut exprimer $C2^*$ en fonction des entrées inversées, c'est-à-dire $A1^*$, $B1^*$, $A0^*$, $B0^*$, $C0^*$. On peut montrer que, dans ce cas particulier, l'expression f s'obtient en inversant toutes les variables dans l'équation (1) sans modifier son expression. Ainsi :

$$g(A1,B1,A0,B0,C0)$$

$$= (A1.B1)+(A1+B1).[(A0.B0)+(A0+B0).C0] \tag{3}$$

$$f(A1^*,B1^*,A0^*,B0^*,C0^*) = (A1^*.B1^*)+(A1^*+B1^*).[(A0^*.B0^*)+(A0^*+B0^*).C0^*] \tag{4}$$

Les expressions f et g sont identiques si l'on excepte qu'elles s'appliquent à des variables mutuellement inversées. Le circuit de calcul anticipé de retenue comportera donc un réseau de mise à 1 et un réseau de mise à 0 symétriques par rapport à une ligne de sortie $C2^*$.

L'expression g est constituée de termes simples dans lesquels une seule opération logique du type (X.Y) ou (X+Y) est effectuée. Ainsi, on peut faire correspondre à l'expression g un réseau de cellules parallèles et série de mise à 0.

Une cellule série correspondra à un terme du type (X.Y) et une cellule parallèle correspondra à un terme du type (X+Y). Les cellules sont connectées entre elles en parallèle ou en série selon que les termes simples correspondant de g sont associés respectivement par un opérateur (+) ou (.).

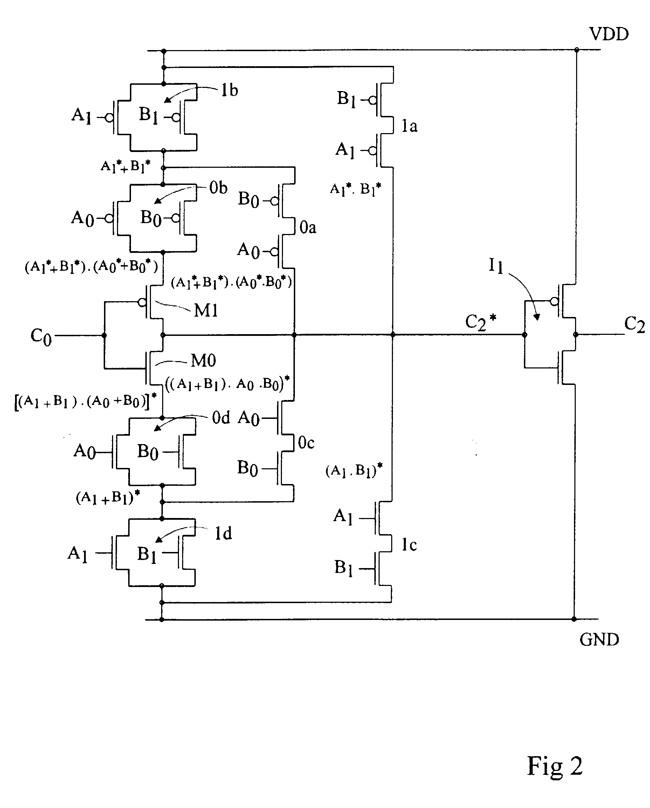

La figure 2 représente un circuit de calcul anticipé de retenue d'un additionneur à 2 bits, ayant la fonction prédéterminée citée. Il comprend un réseau de mise à 1 connecté entre l'alimentation VDD et la ligne de sortie C2* et un réseau de mise à 0 connecté entre la ligne de sortie C2* et la masse GND.

Le réseau de mise à 0 correspondant à l'expression g exprimée par l'équation (3) comprend les éléments suivants :

- un transistor MOS à canal N MO dont la grille est commandée par C0 et le drain connecté à la ligne de sortie C2*,
- une première cellule parallèle de mise à 0 (0d), commandée par A0 et par B0, la borne de drain étant connectée à la borne de source du transistor M0,
- une première cellule série de mise à 0 (0c), commandée par A0 et par B0, la borne de drain étant connectée à la ligne de sortie C2*, la borne de source étant connectée à la borne de source de la première cellule parallèle 0d,
- une deuxième cellule parallèle de mise à 0 (1d), commandée par A1 et par B1, la borne de drain étant connectée à la borne de source des cellules 0d et 0c,
- une deuxième cellule série de mise à 0 (1c), commandée par A1 et par B1, la borne de drain étant connectée à la ligne de sortie C2*, la borne de source étant connectée à la borne de source de la deuxième cellule parallèle 1d et à la masse GND.

Le réseau de mise à 1 correspondant à l'expression f exprimée par l'équation (4) comprend symétriquement au réseau de mise à 0, les éléments suivants :

- un transistor MOS à canal P M1 dont la grille est commandée par C0 et le drain connecté à la ligne de sortie C2*,
- une première cellule parallèle de mise à 1 (0b), commandée par A0 et par B0, la borne de drain étant connectée à la borne de source du transistor M1,
- une première cellule série de mise à 1 (0a), commandée par A0 et par B0, la borne de drain étant connectée à la ligne de sortie C2*, la borne de source étant connectée à la borne de source de la première cellule parallèle 0b,
- une deuxième cellule parallèle de mise à 1 (1b), commandée par A1 et par B1, la borne de drain étant connectée à la borne de source des cellules 0b, 0a,
- une deuxième cellule série de mise à 1 (1a), commandée par A1 et par B1, la borne de drain étant connectée à la ligne de sortie C2*, la borne de source étant connectée à la borne de source de la deuxième cellule parallèle 1b et à l'alimentation VDD.

Enfin, le circuit combinatoire de calcul anticipé de retenue de la figure 2 comprend un inverseur I1 pour fournir le niveau C2 à partir de la ligne de sortie C2*.

<u>EXEMPLE 2 : CIRCUIT DE CALCUL ANTICIPÉ DE RETENUE D'UN ADDITIONNEUR DE DEUX NOMBRES DE n BITS.</u>

On pourra réaliser des circuits de calcul anticipé de retenue d'additionneurs à n bits à entrée de retenue (C0) en généralisant les fonctions citées et en réalisant les circuits correspondants. Ainsi, la fonction logique de calcul de retenue d'un additionneur à n bits est donnée par l'équation (1') :

$$C_{n+1} = (A_n.B_n)+(A_n+B_n).[...[(A_0.B_0)+(A_0+B_0).C_0]] \qquad (1')$$

On en déduit les expressions f et g qui sont à nouveau identiques :

$$g(A_n,B_n,...,A_0,B_0,C_0)$$

$$= (A_n.B_n)+(A_n+B_n).[...[(A_0.B_0)+(A_0+B_0).C_0]] \qquad (3')$$

$$f(A_n^*,B_n^*,..,A_0^*,B_0^*,C_0^*)$$

$$= (A_n^*.B_n^*)+(A_n^*+B_n^*).[...[(A_0^*.B_0^*)+(A_0^*+B_0^*).C_0^*]] \qquad (4')$$

A partir des équations (3'), (4'), on obtient un circuit de calcul anticipé de retenue à n bits de manière itérative, à partir d'un circuit de calcul anticipé de retenue à n-1 bits, en ajoutant les cellules suivantes :

- une cellule parallèle de mise à 0, commandée par An et Bn, entre la cellule parallèle de mise à 0 commandée par An-1, Bn-1 et la masse GND,
- une cellule série de mise à 0, commandée par An et Bn, entre la ligne de sortie et la masse GND,
- symétriquement, une cellule parallèle de mise à 1, commandée par An et Bn, entre la cellule parallèle de mise à 1 commandées par An-1, Bn-1 et l'alimentation VDD,
- symétriquement, une cellule série de mise à 1, commandée par An et Bn, entre la ligne de sortie et l'alimentation VDD.

EXEMPLE 3 : CIRCUIT DE CALCUL ANTICIPÉ DE RETENUE D'UN ADDITIONNEUR DE DEUX NOMBRES DE 4 BITS.

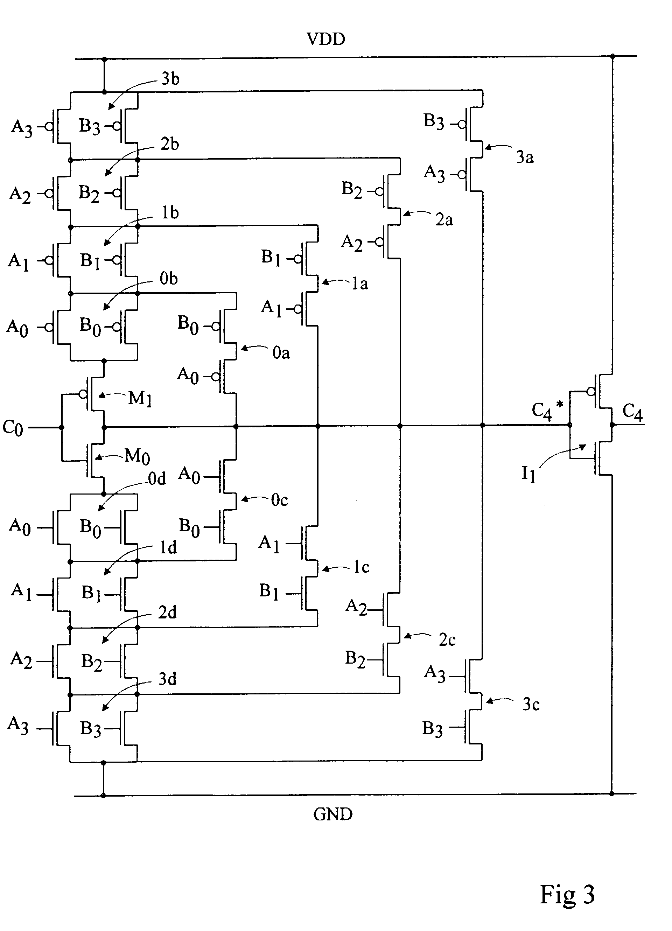

La figure 3 représente ainsi un circuit combinatoire de calcul de retenue d'un additionneur à 4 bits, obtenu à partir du circuit combinatoire de calcul anticipé de retenue de l'additionneur à 2 bits de la figure 2. On a ajouté dans le réseau de mise à O, un module de rang 2, comprenant une cellule parallèle 2d et une cellule série 2c commandées par A2 et par B2, et un module de rang 3 comprenant une cellule parallèle 3d et une cellule série 3c, commandées par A3 et par B3. Symétriquement, dans le réseau de mise à 1, ont été ajoutés deux modules (2b, 2a ; 3b, 3a) comprenant chacun une cellule parallèle et une cellule série de mise à 1, commandés respectivement par A2,B2 et par A3,B3. La ligne de sortie appelée maintenant C4* est connectée à la borne de sortie C4 par l'inverseur I1.

En comparant les figures 2 et 3, on notera que, selon un avantage essentiel de la présente invention, quand on passe d'un additionneur à 2 bits à un additionneur à 4 bits (et plus généralement à un additionneur à n bits), le nombre de couches logiques n'augmente pas et donc que la rapidité du circuit ne change fondamentalement pas si l'on prend soin de conserver la même valeur de la résistance totale de mise à 1 (de mise à 0) par un dimensionnement adéquat des transistors.

ADDITIONNEUR SANS ENTRÉE DE RETENUE

Pour un additionneur sans entrée de retenue (C0), le circuit de calcul anticipé de retenue se simplifie. Pour un additionneur à 2 bits, on a :

$$C2^* = g^*(A1,B1,A0,B0) \qquad = [(A1.B1)+[(A1+B1).(A0.B0)]]^* \qquad (5)$$

$$C2^* = f(A1^*,B1^*,A0^*,B0^*) = (A1^*.B1^*)+[(A1^*+B1^*).(A0^*+B0^*)] \qquad (6)$$

Le circuit combinatoire correspond, par exemple, au circuit de calcul anticipé de retenue d'additionneur à 2 bits à entrée de retenue C0 de la figure 2, en supprimant les cellules 0d et 0a et les transistors M0 et M1 (M1 étant remplacé par un court-circuit). On notera qu'il n'y a plus identité entre les expressions f et g et que le circuit n'est pas symétrique.

De façon générale, on obtiendra un circuit de calcul anticipé de retenue d'additionneur à n bits sans entrée de retenue à partir d'un circuit de calcul anticipé de retenue d'additionneur à n bits en suivant les étapes précédentes.

On notera que la fonction logique du calcul anticipé de retenue d'additionneur n bits sans entrée de retenue peut correspondre à plusieurs circuits qui sont des variantes de celui indiqué précédemment et qui peuvent être obtenues par le procédé selon l'invention. Ainsi, on trouvera aisément un circuit de calcul anticipé de retenue d'additionneur à 2 bits sans entrée de retenue, équivalent au circuit de calcul anticipé de retenue correspondant aux équations (5) et (6), mais ayant un réseau de mise à 0 différent qui correspond à la fonction g suivante :

$$C2^* = g^*(A1,B1,A0,B0) = [(A1+B1).[(A1.B1)+(A0.B0)]]^* \qquad (5')$$

RÉDUCTION DU NOMBRE DE TRANSISTORS EN SÉRIE

La figure 3 illustre un circuit de calcul anticipé de retenue dans lequel chaque réseau comprend, en série entre une tension d'alimentation et une ligne de sortie, quatre cellules parallèles (0b,1b,2b,3b ; 0d,1d,1d,3d) et un transistor MOS (M1 ; M0). Il y a donc cinq transistors en série et l'impédance devient élevée, au détriment de la vitesse de commutation.

Pour conserver une bonne rapidité du circuit, la présente invention prévoit de séparer un groupe de cellules en série d'un réseau et de le remplacer par un transistor MOS inséré à la place du groupe de cellules. Ce transistor MOS est alors commandé par un équivalent du groupe de cellules séparé du réseau comprenant comme on le verra ci-après un groupe "direct" identique au groupe séparé et un groupe "complémentaire".

Cette variante va être décrite dans le cadre du circuit combinatoire de calcul anticipé de retenue à 2 bits de la figure 2. Il sera toutefois clair qu'elle ne présente que peu d'intérêt dans ce cas, mais qu'elle pourra s'appliquer cumulativement à un additionneur à plus grand nombre de bits tel que celui de la figure 3. On réduit ainsi le nombre de transistors en série. La création d'une couche supplémentaire (quel que soit le nombre de bits de l'additionneur) n'intervient pas dans le chemin critique de transfert de retenue, de C0 vers Cn.

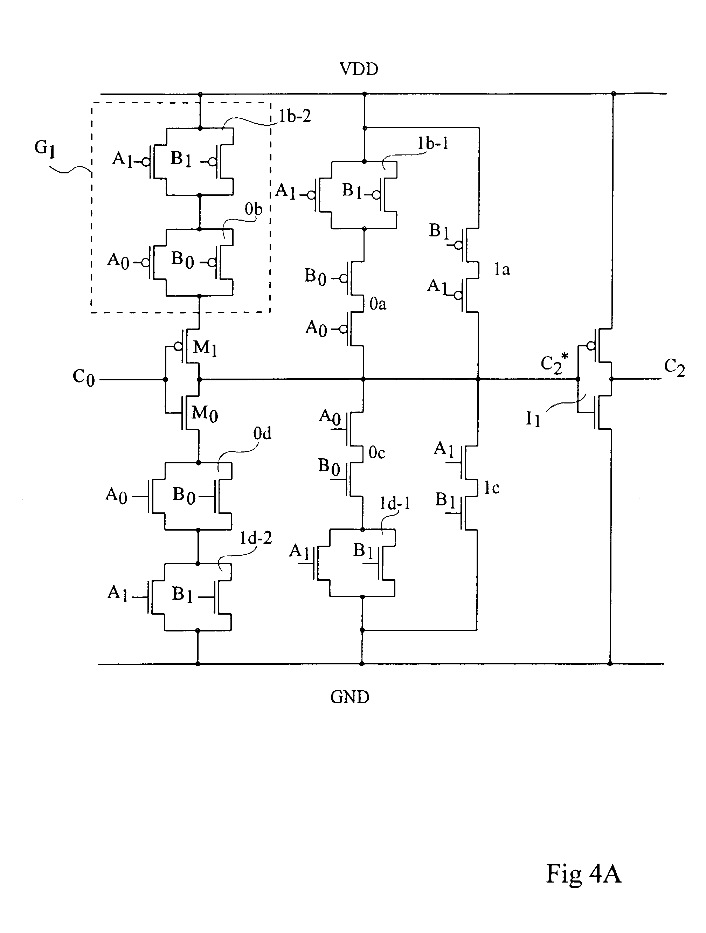

La figure 4A représente une structure ayant exactement la même fonction que celle de la figure 2 mais basée sur une variante d'écriture des équations (3) et (4). Ces équations (3) et (4) étaient :

$$g(A1,B1,A0,B0,C0)$$

$$= (A1.B1)+(A1+B1).[(A0.B0)+(A0+B0).C0] \qquad (3)$$

$$f(A1^*,B1^*,A0^*,B0^*,C0^*)$$

$$= (A1^*.B1^*)+(A1^*+B1^*).[(A0^*.B0^*)+(A0^*+B0^*).C0^*] \qquad (4)$$

et peuvent se réécrire en développant leur deuxième terme:

$$g(A1,B1,A0,B0,C0)$$

$$= (A1.B1)+(A1+B1).(A0.B0)+(A1+B1).(A0+B0).C0 \qquad (7)$$

$$f(A1^*,B1^*,A0^*,B0^*,C0^*)$$

$$= (A1^*.B1^*)+(A1^*+B1^*).(A0^*.B0^*)+(A1^*+B1^*).(A0^*+B0^*).C0^* \qquad (8)$$

En considérant l'expression f, elle se traduit par trois groupes de cellules en parallèle :

- le premier groupe comprend la cellule 1a et correspond à l'opération $(A1^*.B1^*)$ ;
- le deuxième groupe comprend les cellules 0a et 1b-1 en série et correspond à l'opération $(A1^*+B1^*).(A0^*.B0^*)$ ;
- le troisième groupe comprend les cellules 0b et 1b-2 en série avec le transistor M1 et correspond à l'opération

$$(A1^*+B1^*).(A0^*+B0^*).C0^*.$$

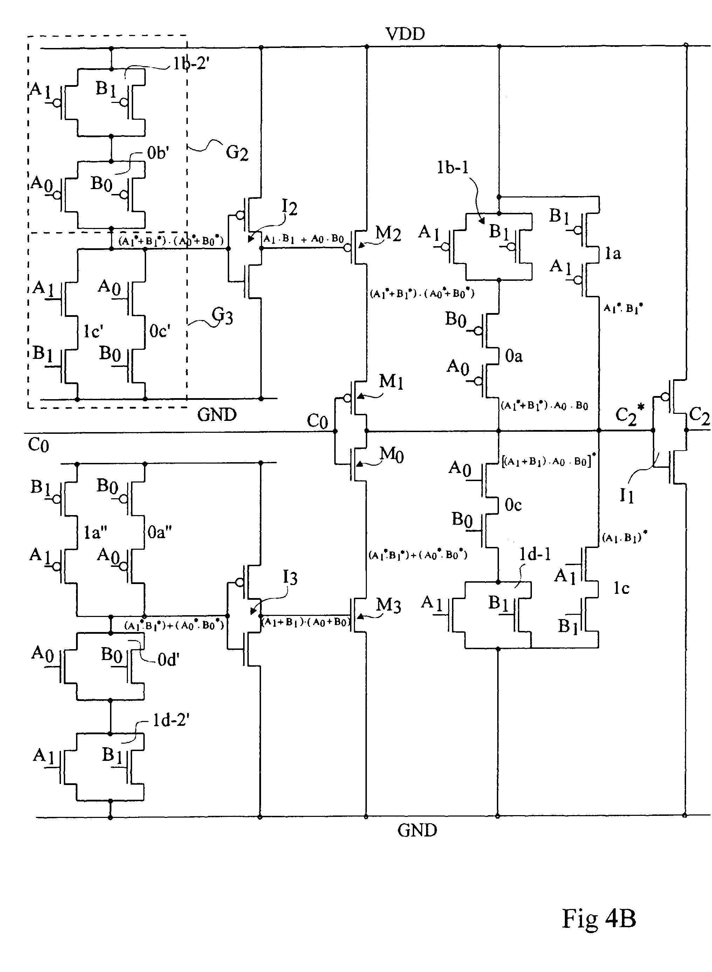

C'est ce troisième groupe, et plus particulièrement le bloc G1 de mise à 1, comprenant les cellules 0b et 1b-2 en série, qui est modifié dans la variante illustrée en figure 4B, ainsi que le groupe symétrique du réseau de mise à 0.

Le bloc G1 est remplacé par un transistor MOS à canal P M2 commandé par un inverseur I2 dont la borne de commande est reliée, d'une part, à l'alimentation VDD par un bloc "direct" G2 et, d'autre part, à la masse GND par un bloc "complémentaire" G3.

Le bloc ou groupe "direct" comprend des cellules 0b' et 1b-2' et est identique au bloc séparé G1. Il a la fonction logique suivante :

$$f(A1^*,B1^*,A0^*,B0^*) = (A1^*+B1^*).(A0^*+B0^*) \qquad (9)$$

Le bloc ou groupe "complémentaire" est obtenu en exprimant la même fonction sous la forme suivante :

$$g^*(A1,B1,A0,B0) = [(A1.B1)+(A0.B0)]^* \qquad (10)$$

Le groupe "complémentaire" de cellules comprend donc deux cellules série de mise à 0, 0c' et 1b', connectées en parallèle entre la masse GND et la ligne de commande de l'inverseur 12.

On a également représenté en figure 4B le réseau de mise à 0 modifié symétriquement par rapport au réseau de mise à 1.

Notons qu'il est également avantageux de remplacer un groupe de cellules connectées en série par un transistor MOS commandé par ce groupe, car le groupe de cellules présente alors une capacité élevée au détriment de la vitesse de commutation.

**Revendications**

1. Procédé de réalisation d'un circuit logique combinatoire fournissant sur au moins une ligne de sortie (C*) une combinaison commutative spécifique d'au moins deux couples d'entrées (A0-B0 ... An-Bn) comprenant les étapes suivantes :

   - établir une première expression (f(A*,B*)) de ladite combinaison comportant uniquement des termes correspondant à des fonctions ET et OU des valeurs inversées desdites entrées ;
   - établir une deuxième expression (g(A,B)) de l'inverse de ladite combinaison comportant uniquement des termes correspondant à des fonctions ET et OU des valeurs non-inversées desdites entrées ;
   - constituer entre une première tension d'alimentation (VDD) et la ligne de sortie (C*), un premier réseau correspondant à la première expression (f(A*,B*)), comprenant :

     .   pour chaque terme ET, une paire d'interrupteurs connectés en série (0a, 1a),
     .   pour chaque terme OU, une paire d'interrupteurs connectés en parallèle (0b, 1b),

   - constituer entre une seconde tension d'alimentation (GND) et la ligne de sortie (C*), un second réseau correspondant à la seconde expression (g(A,B)), comprenant :

     .   pour chaque terme ET, une paire d'interrupteurs connectés en série (0c, 1c),
     .   pour chaque terme OU, une paire d'interrupteurs connectés en parallèle (0d),(1d),

   les interrupteurs d'une paire étant commandés par l'une et l'autre des entrées d'un couple d'entrées, les interrupteurs des premier et second réseaux étant de type complémentaires et étant commandés en phase.

2. Procédé selon la revendication 1, caractérisé en ce qu'il comprend l'étape consistant à remplacer un groupe de cellules (0b, 1b-2) en série entre deux bornes par un interrupteur (M2) connecté entre les deux bornes et précédé d'un inverseur dont l'entrée est connectée à une première ligne d'alimentation par un groupe direct de cellules (0b',1b-2') et à une deuxième ligne d'alimentation par un groupe complémentaire de cellules (0c',1c') ; le groupe direct étant identique au groupe de cellules remplacées ; le groupe complémentaire comprenant pour chaque cellule parallèle du groupe direct, une cellule série, et inversement ; les cellules du groupe complémentaire étant connectées entre elles en série si les cellules du groupe direct sont connectées en parallèle, et inversement.

3. Procédé selon la revendication 1, caractérisé en ce que ladite combinaison est une addition logique.

4. Procédé selon la revendication 1, caractérisé en ce que ladite combinaison est une fonction de calcul anticipé de retenue d'additionneur logique ayant au moins deux fois n entrées (n>1).

5. Procédé selon la revendication 5, caractérisé en ce que l'additionneur logique a une entrée de retenue (C0) et en ce que lesdites première et deuxième expression (f et g) du circuit de calcul anticipé de retenue s'écrivent respectivement :

$$f(An*,Bn*,...,A0*,B0*,C0*)$$
$$= (An*.Bn*)+(An*+Bn*).[...[(A0*.B0*)+(A0*+B0*).C0*]]$$
$$g(An,Bn,...,A0,B0,C0)$$
$$= (An.Bn)+(An+Bn).[...[(A0.B0)+(A0+B0).C0]]$$

6. Circuit logique combinatoire comprenant au moins n couples d'entrées (A,B) (où n est srictement supérieur à 1) et une ligne de sortie (C*), caractérisé en ce qu'il comprend au moins n premiers modules (1b,1a) et n modules symétriques (1d,1c) ; un premier module comprenant une cellule parallèle (1b) et une cellule série (1a) ; une cellule parallèle (1b) comprenant deux interrupteurs commandés par un couple d'entrées et en parallèle entre une borne d'alimentation couplée à une première tension d'alimentation (VDD) et une borne de sortie couplée à la ligne de sortie ; une cellule série (1a) comprenant deux interrupteurs commandés par ledit couple d'entrées et en série entre ladite borne d'alimentation et la ligne de sortie ; la borne d'alimentation de la cellule parallèle de chaque module (ka,kb) de rang k (k variant de 1 à n-1) étant connectée à la borne de sortie de la cellule du module de rang k+1 ; un module symétrique comprenant deux cellules complémentaires et symétriques de celles du premier module par rapport à la ligne de sortie, couplées à une seconde tension d'alimentation (GND) et commandées en phase.

7. Circuit logique combinatoire selon la revendication 6, comprenant une autre paire d'entrée (A0,B0), caractérisé en ce que la borne de sortie de la cellule parallèle (1b) du module (1a,1b) de rang 1 est connectée à la ligne de sortie (C2*) par deux interrupteurs en parallèle (0b) commandés respectivement par les entrées de l'autre paire d'entrée (A0,B0), la borne de sortie de la cellule symétrique (1d) à la cellule parallèle (1b) du module (1a,1b) de rang 1 étant connectée à la ligne de sortie (C2*) par deux interrupteurs en série (0c), commandés respectivement par les entrées de l'autre paire d'entrée (A0,B0).

8. Circuit logique combinatoire selon la revendication 6, caractérisé en ce qu'il comprend une entrée supplémentaire (C0) et deux interrupteurs supplémentaires commandés par l'entrée supplémentaire en opposition de phase, la borne de sortie de la cellule parallèle (0b) du module de rang 1 étant connectée à la ligne de sortie (C2*) par l'un des deux interrupteurs supplémentaires, la borne de sortie de la cellule parallèle (0d) du module symétrique de rang 1 étant connectée à la ligne de sortie (C2*) par l'autre interrupteur supplémentaire.

Fig 1A          (X*.Y*)

Fig 1B          (X*+Y*)

Fig 1C          (X.Y)*

Fig 1D          (X+Y)*

Fig 2

Fig 3

VDD

Fig 4A

Fig 4B

Office européen
des brevets

**RAPPORT DE RECHERCHE EUROPEENNE**

Numero de la demande

EP 96 41 0057

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| D,X<br>A | WO-A-85 05705 (MOTOROLA)<br>* page 22, ligne 16 - page 23, ligne 18; figures 7A,7B *<br>--- | 1,3,5<br>6 | G06F7/50<br>H03K19/173<br>H03K19/0948 |
| X<br><br>A | EP-A-0 453 600 (DEUTSCHE ITT INDUSTRIES GMBH)<br>* colonne 7, ligne 5 - colonne 13, ligne 55; figures 2-6 *<br>--- | 1,3,5<br><br>6 | |
| D,X<br>A | US-A-4 601 007 (UYA ET AL.)<br>* figure 2 - repères 3 et 4 *<br><br>--- | 1<br>6 | |
| D,X<br><br><br><br><br>A | IBM TECHNICAL DISCLOSURE BULLETIN,<br>vol. 30, no. 7, Décembre 1987, ARMONK, NY, US,<br>pages 132-133, XP000021747 "High speed and high density full adder"<br>* le document en entier *<br>--- | 1<br><br><br><br><br>6 | |
| X<br><br><br>A | DE-A-38 40 948 (FRAUNHOFER-GESELLSCHAFT ZUR FÖRDERUNG DER ANGEWANDTEN FORSCHUNG EV)<br>* colonne 6, ligne 10 - ligne 14; figure 3 *<br>--- | 1<br><br><br>6 | DOMAINES TECHNIQUES RECHERCHES (Int.Cl.6)<br><br>G06F<br>H03K |
| A | US-A-4 651 296 (KOIKE)<br>* le document en entier *<br>----- | 1,6 | |

Le présent rapport a été établi pour toutes les revendications

| Lieu de la recherche | Date d'achèvement de la recherche | Examinateur |
|---|---|---|
| BERLIN | 9 Septembre 1996 | Taylor, P |

**CATEGORIE DES DOCUMENTS CITES**

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
..................................................................
& : membre de la même famille, document correspondant

EPO FORM 1503 03.82 (P04C02)